# EUROPEAN PATENT SPECIFICATION

(11) **EP 0 487 325 B1**
(45) Date of publication and mention of the grant of the patent: **15.05.1996**
(21) Application number: 91310699.3
(22) Date of filing: 20.11.1991
(51) Int. Cl.: H05K 13/08, H05K 13/04

(54) **Method and apparatus for electronic component lead inspection**
Verfahren und Vorrichtung zur Inspektion von Zuleitungen von elektronischen Komponenten
Procédé et dispositif pour inspecter les conducteurs d'un composant électronique

(30) Priority: 20.11.1990 US 616287
(43) Date of publication of application: 27.05.1992
(73) Proprietor: International Business Machines Corporation, Armonk, N.Y. 10504 (US)
(72) Inventor: Beers, Gregory Edward, Austin, Texas 78758 (US); Bogaczyk, Francis Walter, Austin, Texas 78750 (US); Rubsam, Michael Alan, Austin, Texas 78727 (US); Wattenbarger, Henry Edison, Pflugerville, Texas 78660 (US)
(74) Representative: Burt, Roger James, Dr.

(56) References cited:
- US-A- 3 574 923
- US-A- 4 604 648
- US-A- 4 728 195
- PATENT ABSTRACTS OF JAPAN, vol. 11, no. 143 (E-504)9 May 1987;& JP-A-61 280 628
- PATENT ABSTRACTS OF JAPAN, vol. 12, no. 203 (P-715)(3050) 11 June 1988;& JP-A- 63 005 243
- IBM TECHNICAL DISCLOSURE BULLETIN, vol. 30, no. 4, 1 September 1987, NEW YORK US pages 1506 - 1508; UNKNOWN: 'OPTICAL INSPECTION/ALIGNMENT OF MULTISIDED COMPONENT CONNECTIONS'

## Description

The present invention relates to the field of integrated circuit device assembly and inspection and particularly to systems and methods for the inspection of integrated circuit device conductive leads.

The increasing complexity of electronic systems along with a concomitant increase in packaging densities has resulted in an increased utilisation of automated device handling. Modern robotic systems are often utilised to assemble electronic systems and bring an increased reliability to highly repetitive operations, such as integrated circuit device mounting and placement. Often an integrated circuit device is picked up by a robotic arm and placed on a circuit board to be temporarily held in place by a tacky substance, such as flux. Subsequently, a hot bar thermode, or other similar device is utilised to permanently bond the device to the circuit board.

Despite the increased efficiency and accuracy of robotic systems in placing and mounting integrated circuit devices on circuit boards, it is still necessary to inspect each integrated circuit device prior to mounting the device to ensure that the device is in a proper orientation and that all conductive leads are present and properly oriented to ensure proper conductive mounting. In the prior art this is often accomplished by utilising optical inspection techniques prior to placing each integrated circuit device at a mounting location; however, these systems require each integrated circuit device to be moved into an inspection area, inspected, and the moved again to the mounting position.

Experience with such systems has shown that it is likely that an integrated circuit device may be damaged after inspection during the process of transporting that device to a mounting point. A need exists for a method and apparatus which permits an integrated circuit device to be inspected prior to mounting the device without requiring unnecessary handling of the device. One problem which must be overcome in such a system in the difficulty which is encountered in attempting to optically inspect an integrated circuit device while such device is present within a mounting tool, within the bonding tool shown in US-A-3 574 923.

Viewed from one aspect the present invention provides apparatus for inspecting conductive leads of an integrated circuit device, the apparatus comprising: a hot bar thermode having one or more heatable blades for bonding conductive leads of an integrated circuit device to a mounting surface; means for mounting an integrated circuit device in a plane adjacent to the hot bar thermode whereby conductive leads of the integrated circuit device are disposed adjacent a surface of the one or more heatable blades; and means for illuminating the conductive leads disposed adjacent to a surface of one of the heatable blades at a low angle relative to the plane so as to highlight the conductive leads which shade the surface of the heatable blade thereby providing for visual inspection of the conductive leads.

Viewed from another aspect the present invention provides a method for inspecting conductive leads of an integrated circuit device, the method comprising the steps of: providing a hot bar thermode having one or more heatable blades for bonding conductive leads of an integrated circuit device to a mounting surface; mounting an integrated circuit device in a plane adjacent to the hot bar thermode whereby the conductive leads of the integrated circuit device are disposed adjacent to a surface of the one ore more heatable blades; and illuminating the conductive leads at a low angle with respect to the plane so as to highlight the conductive leads which shade the surface of the heatable blade, thereby creating a high contrast between the conductive leads and the plurality of heatable blades.

In order that the invention may be fully understood preferred embodiments thereof will now be described, by way of example only, with reference to the accompanying drawings in which:
**Figure 1** is a pictorial representation of an integrated circuit inspection and assembly device constructed in accordance with the present invention;
**Figure 2** is a plan view of the bottom of an integrated circuit mounted within the assembly device of **Figure 1**;
**Figure 3** is an exploded view of a portion of the integrated circuit and assembly device of **Figure 2**;
**Figure 4** is a pictorial representation of an inspection site and illumination system which may be utilised with an embodiment of the present invention; and
**Figure 5** is a partial side view of an integrated circuit device mounted and illuminated in accordance with the embodiment of **Figure 4**.

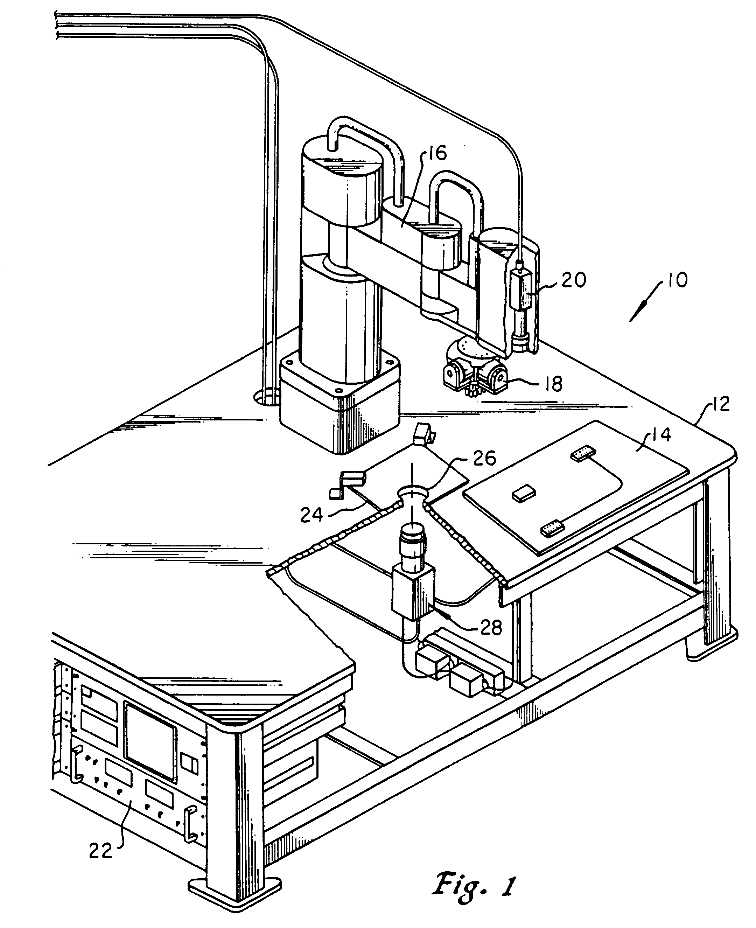

With reference now to the figures and in particular with reference to **Figure 1**, there is depicted a pictorial representation of an integrated circuit inspection and assembly device constructed in accordance with the present invention. As is illustrated, inspection and assembly device **10** includes a mounting table **12**, which serves to support the various assembly and inspection areas which are illustrated thereon. For example, circuit board assembly station **14** is illustrated and serves to accurately and rigidly mount a circuit board which will be populated by integrated circuit devices which are tested and assembled utilising the device as illustrated.

A robotic arm **16** is preferably provided, in accordance with robotic techniques known in the prior art. Robotic arm **16** serves to mount a heating element or other device for bonding an integrated circuit device to a circuit. One such device is hot bar thermode tool **18**. Robotic arm 16 also serves to pick up, hold during inspection and place an integrated circuit device. Also mounted to robotic arm **16** is device placement camera **20**, which is utilised to accurately locate a placement site for each integrated circuit device.

Situated beneath mounting table **12** are a vacuum pump and various control electronics **22**, which are utilised, in accordance with methods known in the prior art, to control the movement of robotic arm **16** and to provide a vacuum to a vacuum chuck (not illustrated) within hot bar thermode tool **18**, so that an integrated circuit device may be selectively and temporarily held therein.

Also depicted on the upper surface of mounting table **12** is inspection station **24**. Inspection station **24** is utilised, in accordance with the method of the present invention, to provide an area wherein specific illumination is provided so that an integrated circuit device may be optically inspected. Located within inspection station **24** is inspection aperture **26**, which serves to permit inspection camera **28** to focus on an integrated circuit device contained within hot bar thermode tool **18** when hot bar thermode tool **18** is positioned, by means of robotic arm **16**, directly above inspection aperture **26**.

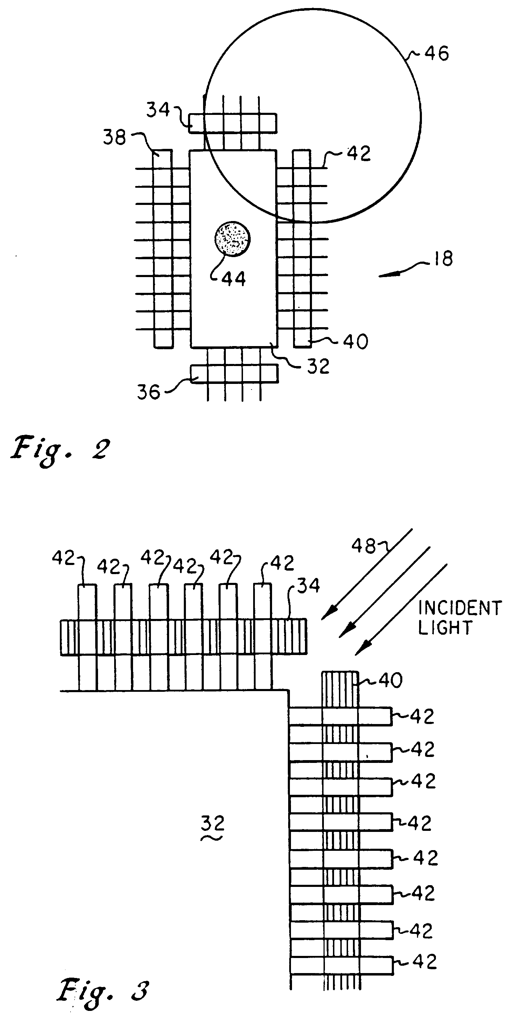

Referring now to **Figure 2**, there is depicted a plan view of the bottom of an integrated circuit which is held within the assembly device of **Figure 1**. As is illustrated, an integrated circuit **32** is depicted as held within hot bar thermode tool **18**. A vacuum chuck **44** is depicted and is utilised in conjunction with a vacuum pump to selectively and temporarily hold integrated circuit **32** within hot bar thermode tool **18**.

As is illustrated, hot bar thermode tool **18** includes a plurality of thermally activatable blades **34**, **36**, **38**, and **40** which are, in a preferred embodiment of the present invention electrically thermally activatable in order to assemble integrated circuit device **32** to a circuit board by melting solder in the vicinity of each conductive lead **42**. As is depicted in **Figure 2**, integrated circuit device **32**, including a plurality of conductive leads **42** which overlay lower surfaces of the plurality of thermally activatable blades present within hot bar thermode tool **18**.

With reference now to **Figures 2** and **3**, area **46** of integrated circuit **32** and hot bar thermode tool **18** is shown in an exploded view within **Figure 3**. As is illustrated, a plurality of conductive leads **42**, which are electrically connected to selected portions of integrated circuit **32**, are positioned in an overlying fashion with respect to the lower surfaces of thermally activatable blades **34** and **40**. In accordance with a feature of one embodiment of the present invention, thermally activatable blades **34** and **40** have been produced with a grained finish in a substantially single direction.

This grained finish is preferably produced by grinding, sanding, lapping or any other grain producing operation. As long as the grain direction on the lower surface of thermally activatable blades **34** and **40** is produced in a single direction, the lower surfaces of thermally activatable blades **34** and **40** will act much like a Fresnel lens and will have a uniform and minimum specularity, appearing dark.

Conductive leads **42**, however, typically constructed of a gold or silver metallic substance, will have a uniform and highly reflective surface, appearing bright. The contrast between the lower surface of thermally activatable blade **34** and **42** and conductive leads **40** will be maximised by providing incident light **48** at an angle of between thirty and sixty degrees to the direction of the grain on the lower surfaces of thermally activatable blades **34** and **40**.

In a preferred embodiment of the present invention, incident light **48** is applied to the juncture of conductive leads **42** and the grained lower surfaces of thermally activatable blades **34** and **40** at an angle of approximately forty five degrees to the direction of the grain which is placed within the lower surface of thermallyl activatable blades **34** and **40**. In this manner, inspection camera **28** (see **Figure 1**) may be utilised to provide an accurate visual inspection of conductive leads **42** while integrated circuit **32** is mounted within hot bar thermode tool **18**.

This technique obviates the requirement of inspecting integrated circuit **32** in a first position and then subsequently transferring of integrated circuit **32** to an assembly position by picking the device up and moving it with a different tool. The elimination of this second transfer step renders the system much more efficient by eliminating the possibility that a conductive lead may be bent or damaged during a subsequent transfer of integrated circuit **32**.

By inspecting integrated circuit **32** while it is within a mounting tool the efficiency and accuracy of the construction of an electronic system may be greatly enhanced. As utilised herein, the term "hot bar thermode tool" shall mean any device which may be utilised to thermally mount an integrated circuit device to a circuit board.

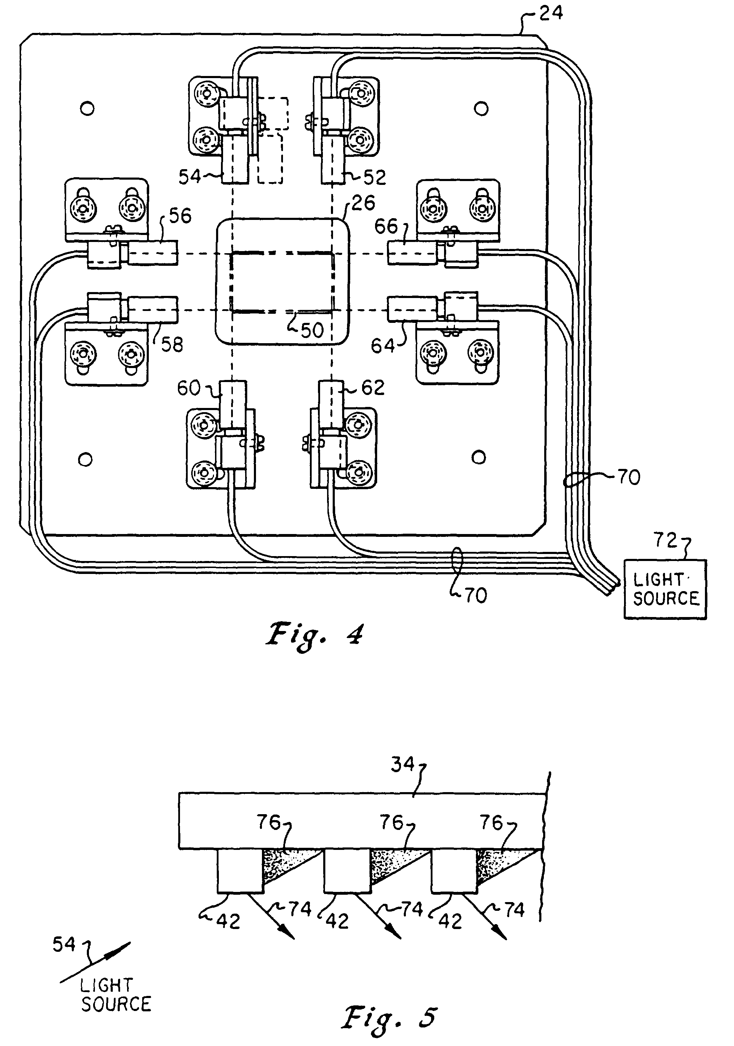

Referring now to **Figure 4**, there is depicted a pictorial representation of an inspection site and illumination system which may be utilised in accordance with another embodiment of the present invention. As is illustrated, inspection station **24**, as illustrated in **Figure 4**, includes an inspection aperture **26** through which inspection camera **28** can provide an accurate optical inspection of conductive leads **42** of integrated circuit device **32** (see **Figure 2**).

As illustrated in **Figure 4**; an integrated circuit device profile **50** is depicted within inspection aperture **26** and is generally rectangular or square in shape. As those skilled in the art will appreciate upon reference to **Figure 2**, integrated circuit devices of the type utilised in high density electronic systems typically have a plurality of conductive leads disposed along all four sides of a circuit device. In accordance with an important feature of this embodiment of the present invention a plurality of light stations **52**, **54**, **56**, **58**, **60**, **62**, **64**, and **66** are provided.

Each of the aforementioned light station cooperates, as illustrated in **Figure 4**, with a second light station which is disposed on a line opposite to its cooperating light station. That is, light station **54** cooperates with light station **60** to illuminate the left hand edge of integrated circuit device profile **50**. Similarly, light station **52** cooperates with light station **62** to illuminate the right hand edge of integrated circuit device profile **50**, and so on.

In this manner, each edge of an integrated circuit device can be thoroughly illuminated by utilising the plurality of light inspection stations depicted. In the depicted embodiment of the present invention, each light station preferably comprises a dual stacked light with two sources of light focused utilising bi-convex lenses projecting oval patterns. Each light is preferably focused at an intermediate point along one of the thermally activatable blades of hot bar thermode tool **18** (see **Figure 2**) such that the conductive leads **42** disposed adjacent thereto will be illuminated.

By focusing the output of each light station at a low angle with respect to the plane wherein integrated circuit **32** (see **Figure 2**) is mounted the contrast between conductive leads **42** and each thermally activatable blade of hot bar thermode tool **18** may be enhanced by projecting a shadow on those portions of each thermally activatable blade which are exposed between adjacent conductive leads **42**. This technique will be illustrated in greater detail in **Figure 5** herein.

In accordance with another aspect of the present invention, it can be seen in **Figure 4** that each light station mounted therein is connected via a fibre optic cable **70** to a light source **72**. By utilising equal length fibre optic cables **70** and a single light source **72**, the amount of illumination which is focused on each group of conductive leads **42** will preferably be substantially equal. In this manner, the threshold levels which are utilised by inspection camera **28** to detect the presence or absence of a conductive lead may be accurately set for each edge of integrated circuit device **32**.

Finally with reference to **Figure 5**, there is depicted a partial side view of an integrated circuit device which is mounted and illuminated in accordance with the embodiment of **Figure 4**. As is illustrated, a plurality of conductive leads **42** are disposed in an overlying relationship with thermally activatable blade **34** of hot bar thermode tool **18**. A low angle light source **54**, such as provided by light station **54**, is then utilised to illuminated conductive leads **42**. Due to the fact that conductive leads **42** are tipically constructed of a gold or silver material and are highly reflective in nature, a great deal of light will be reflected from the surface of each conductive lead **42**, as illustrated at reference numerals **74**.

Additionally, a shadowed area **76** is provided on the lower surface of thermally activatable blade **34** of hot bar thermode tool **18** by the presence of each conductive lead **42**. Thus, it may be seen that by the provision of a low angle source of illumination, relative to the plane in which integrated circuit **32** is mounted, the resultant shadows on each thermally activatable blade of hot bar thermode tool **18** may be utilised to provide a high degree of contrast between each conductive lead **42** and underlying thermally activatable blade.

As a result, a highly accurate optical inspection of conductive leads **42** may be obtained while integrated circuit device **32** is mounted within hot bar thermode tool **18**. In a preferred embodiment of the present invention each light station of inspection station **24** of **Figure 4** is mounted so as to focus a beam of light on conductive leads **42** of integrated circuit device **32** at an angle of between ten and thirty degrees with respect to the plane in which integrated circuit device **32** is mounted.

An improved integrated circuit device inspection and assembly system has been described. A method and apparatus in accordance with the present invention permits the visual inspection of electronic component leads during the mounting thereof. A hot bar thermode or other mounting tool or heating element having a plurality of thermally activatable blades has been described. A vacuum chuck and associated vacuum pump are utilised to selectively mount an integrated circuit device such that the conductive leads of the device are disposed adjacent to the lower surfaces of the thermally activatable blades. A low angle light source is then utilised to illuminate the integrated circuit device conductive leads such that a high contrast is created between the conductive leads and the lower surface of the thermally activatable blades, in order to permit an accurate visual inspection of the conductive leads. In one embodiment of the present invention, the lower surfaces of the thermally activatable blades are given a uniform grain by lapping those surfaces in a single direction to reduce the specularity of these surfaces and the angle of illumination is adjusted to enhance the contrast between the conductive leads and the lower blade surfaces. A camera disposed below the hot bar thermode may then be utilised to permit remote visual inspection of the conductive leads of an integrated circuit device while it is present within the mounting tool. By inspecting the conductive leads of an integrated circuit device while the device is preset within a mounting tool, the possibility of further damage to the conductive leads prior to mounting the integrated circuit device on a circuit board are substantially reduced.

While the invention has been particularly shown and described with reference to a preferred embodiment, it will be understood by those skilled in the art that various changes in form and detail may be made therein without departing from the scope of the invention as defined in the appended claims.

## Claims

1. Apparatus for inspecting conductive leads of an integrated circuit device, the apparatus comprising:
a hot bar thermode (18) having one or more heatable blades (34-40) for bonding conductive leads (42) of an integrated circuit device (32) to a mounting surface;
means (44) for mounting an integrated circuit device (32) in a plane adjacent to the hot bar thermode (18) whereby conductive leads (42) of the integrated circuit device (32) are disposed adjacent a surface of the one or more heatable blades (34-40); and characterised by
means (54) for illuminating the conductive leads (42) disposed adjacent to a surface of one of the heatable blades (34) at a low angle relative to the plane so as to highlight the conductive leads (42) which shade the surface (76) of the heatable blade (34) thereby providing for visual inspection of the conductive leads (42).

2. Apparatus as claimed in Claim 1 wherein the angle relative to the plane has a value between 10 and 30 degrees.

3. Apparatus as claimed in Claim 1 or 2 wherein the mounting means comprises a vacuum chuck (44) and means (22) for selectively activating an associated vacuum pump.

4. Apparatus as claimed in any of the preceding Claims further comprising a camera (28) for providing an image of the conductive leads (42).

5. Apparatus as claimed in any of the preceding Claims wherein the surface of the heatable blade (34) has a grained finish, the grain being in one direction.

6. Apparatus as claimed in any of the preceding Claims wherein the illuminating means (54) comprises a light source (72) and a plurality of fibre optic cables (70) for directing a plurality of light beams (52-66) and thereby illuminating the conductive leads (42) from multiple positions.

7. Apparatus as claimed in any claims 1 to 5 wherein the illuminating means (54) comprises two or more sources of light focused at the conductive leads (42) at an angle to said single direction of the grain, the angle being between thirty and sixty degrees.

8. A method for inspecting conductive leads of an integrated circuit device, the method comprising the steps of:
providing a hot bar thermode (18) having one or more heatable blades (34-40) for bonding conductive leads (42) of an integrated circuit device (32) to a mounting surface;
mounting an integrated circuit device (32) in a plane adjacent to the hot bar thermode (18) whereby conductive leads (42) of the integrated circuit device (32) are disposed adjacent a surface of the one or more heatable blades (34-40); and characterised by the step of
illuminating the conductive leads (42) disposed adjacent to a surface of one of the heatable blades (34) at a low angle relative to the plane so as to highlight the conductive leads (42) which shade the surface (76) of the heatable blade (34) thereby providing for visual inspection of the conductive leads (42).

## Patentansprüche

1. Vorrichtung zur Prüfung von leitenden Zuleitungen einer integrierten Schalteinheit, wobei die Vorrichtung enthält:
eine Löteinrichtung (18) mit einem oder mehreren heizbaren Kolben (34-40), um die leitenden Zuleitungen (42) einer integrierten Schalteinheit (32) auf einer Montagefläche zu bonden;
Mittel (44), um eine integrierte Schalteinheit (32) auf einer Fläche zu montieren, die sich in der Nähe der Löteinrichtung (18) befindet, wobei die leitenden Zuleitungen (42) der integrierten Schalteinheit (32) in der Nähe einer Fläche von einem oder mehreren heizbaren Kolben (34-40) angeordnet sind; und gekennzeichnet wird durch
Mittel (54), um die leitenden Zuleitungen (42), die in der Nähe einer Fläche von einem der heizbaren Kolben (34) in einem niedrigen Winkel bezogen auf die Fläche angeordnet sind, zu beleuchten, um so die leitenden Zuleitungen (42), welche die Fläche (76) des heizbaren Kolbens (34) beschatten, zu erhellen, wobei die visuelle Prüfung der leitenden Zuleitungen (42) bereitgestellt wird.

2. Vorrichtung wie in Anspruch 1 angemeldet, wobei der Winkel bezogen auf die Fläche einen Wert zwischen 10 und 30 Grad hat.

3. Vorrichtung wie in Anspruch 1 oder 2 angemeldet, wobei die Montagemittel eine Unterdruckspannvorrichtung (44) und Mittel (22) enthalten, um selektiv eine zugehörige Vakuumpumpe zu aktivieren.

4. Vorrichtung wie in irgendeinem der vorhergehenden Ansprüche angemeldet, die außerdem eine Kamera (28) enthält, um ein Bild von den leitenden Zuleitungen (42) zu liefern.

5. Vorrichtung wie in irgendeinem der vorhergehenden Ansprüche angemeldet, wobei die Fläche des heizbaren Kolbens (34) eine gekörnte Oberfläche aufweist, deren Körnung in einer Richtung verläuft.

6. Vorrichtung wie in irgendeinem der vorhergehenden Ansprüche angemeldet, wobei die Beleuchtungsmittel (54) eine Lichtquelle (72) und eine Vielzahl von faseroptischen Kabeln (70) enthalten, um eine Vielzahl von Lichtstrahlen (52-66) zu steuern und dadurch die leitenden Zuleitungen (42) aus zahlreichen Positionen zu beleuchten.

7. Vorrichtung wie in irgendeinem der Ansprüche 1 bis 5 angemeldet, wobei die Beleuchtungsmittel (54) zwei oder mehr Lichtquellen enthalten, die auf die leitenden Zuleitungen (42) in einem Winkel zu der in einer Richtung verlaufenden Körnung fokussiert werden, wobei der Winkel zwischen dreißig und sechzig Grad ist.

8. Ein Verfahren zur Prüfung von leitenden Zuleitungen einer integrierten Schalteinheit, wobei das Verfahren Schritte enthält, um
eine Löteinrichtung (18) mit einem oder mehreren heizbaren Kolben (34-40) zum Bonden der leitenden Zuleitungen (42) einer integrierten Schalteinheit (32) auf einer Montagefläche bereitzustellen;
eine integrierte Schalteinheit (32) in einer Fläche zu montieren, die sich in der Nähe der Löteinrichtung (18) befindet, wobei die leitenden Zuleitungen (42) der integrierten Schalteinheit (32) in der Nähe einer Fläche von einem oder mehreren heizbaren Kolben (34-40) angeordnet sind; und durch den Schritt gekennzeichnet wird, um
die leitenden Zuleitungen (42), die in einer Fläche von einem der heizbaren Kolben (34) in einem niedrigen Winkel bezogen auf die Fläche angeordnet sind, zu beleuchten, um so die leitenden Zuleitungen (42) zu erhellen, welche die Fläche (76) des heizbaren Kolbens (34) beschatten, wodurch die visuelle Prüfung der leitenden Zuleitungen (42) bereitgestellt wird.

## Revendications

1. Appareil pour inspecter les fils conducteurs d'un composant à circuit intégré, ledit appareil comprenant :
une thermode à barre chaude (18) comprenant une ou plusieurs lames chauffables (34 à 40) pour souder les fils conducteurs (42) d'un composant à circuit intégré (32) à une surface de montage ;
un élément (44) pour monter un composant à circuit intégré (32) dans un plan contigü à la thermode à barre chaude (18), les fils conducteurs (42) du composant à circuit intégré (32) étant disposés de manière contiguë à une surface d'au moins une des lames chauffables (34 à 40) ; caractérisé en ce qu'il comprend :
un élément (54) pour éclairer les fils conducteurs (42) disposés de manière contiguë à une surface de l'une des lames chauffables (34) selon un angle plat par rapport au plan de façon à mettre en évidence les fils conducteurs (42) qui ombrent la surface (76) de la lame chauffante (34) pour permettre l'inspection visuelle des dits fils conducteurs (42).

2. Appareil selon la revendication 1, dans lequel l'angle par rapport au plan est compris entre 10 et 30 degrés.

3. Appareil selon la revendication 1 ou 2, dans lequel l'élément de montage comprend une ventouse (44) et un élément (22) pour activer sélectivement une pompe à vide associée.

4. Appareil selon l'une quelconque des revendications précédentes comprenant, de plus, un appareil de prise de vue (28) pour fournir une image des fils conducteurs (42).

5. Appareil selon l'une quelconque des revendications précédentes, dans lequel la surface de la lame chauffable (34) a un fini grainé, le grain ayant un sens donné.

6. Appareil selon l'une quelconque des revendications précédentes, dans lequel le dispositif d'éclairage (54) est composé d'une source lumineuse (72) et d'une pluralité de câbles à fibre optique (70) pour diriger une pluralité de faisceaux lumineux (52 à 66) et éclairer, ainsi, les fils conducteurs (42) depuis des positions multiples.

7. Appareil selon les revendications 1 à 5, dans lequel le dispositif d'éclairage (54) est composé d'au moins deux sources lumineuses focalisées sur les fils conducteurs (42) selon un angle compris entre trente et soixante degrés par rapport au dit sens du grain.

8. Procédé pour inspecter les fils conducteurs d'un composant à circuit intégré, ledit procédé comprenant les étapes consistant à :
prévoir une thermode à barre chaude (18) comprenant une ou plusieurs lames chauffables (34 à 40) pour souder les fils conducteurs (42) d'un composant à circuit intégré (32) à une surface de montage ;
monter un composant à circuit intégré (32) dans un plan contigü à la thermode à barre chaude (18), les fils conducteurs (42) du composant à circuit intégré (32) étant disposés de manière contiguë à une surface d'au moins une des lames chauffables (34 à 40) ; ledit procédé étant caractérisé en ce qu'il comprend l'étape consistant à :
éclairer les fils conducteurs (42) disposés de manière contiguë à une surface de l'une des lames chauffables (34) selon un angle plat par rapport au plan de façon à mettre en évidence les fils conducteurs (42) qui ombrent la surface (76) de la lame chauffante (34) pour permettre l'inspection visuelle des dits fils conducteurs (42).
